# EUROPÄISCHE PATENTSCHRIFT

(11) **EP 0 155 403 B1**
(45) Veröffentlichungstag und Bekanntmachung des Hinweises auf die Patenterteilung: **03.03.1993**
(21) Anmeldenummer: 84116253.0
(22) Anmeldetag: 22.12.1984
(51) Int. Cl.: G06F 13/42, G11C 17/00, F02P 5/15

(54) **Steuergerät für Kraftfahrzeuge**
Control device for motor vehicles
Dispositif de commande pour véhicules à moteur

(30) Priorität: 20.03.1984 DE 3410082
(43) Veröffentlichungstag der Anmeldung: 25.09.1985
(73) Patentinhaber: ROBERT BOSCH GMBH, 70442 Stuttgart (DE)
(72) Erfinder: Henn, Michael, Dipl.-Ing., D-7000 Stuttgart 1 (DE); Hersel, Walter, Dr. Dipl.-Phys., D-7064 Remshalden 3 (DE); Hertzler, Siegfried, Dipl.-Ing., D-7000 Stuttgart 40 (DE); Jautelat, Rüdiger, Dipl.-Ing., D-7141 Schwieberdingen (DE); Jundt, Werner, Dipl.-Ing., D-7140 Ludwigsburg (DE); Kaiser, Günther, Dr. Dipl.-Phys., D-7000 Stuttgart 40 (DE); Kirschner, Michael, Dipl.-Ing., D-7530 Pforzheim (DE); Mayer, Dieter, Dipl.-Ing., D-7988 Wangen/A. (DE); Meyer, Klaus-Gerd, Dipl.-Ing., D-2900 Oldenburg (DE); Mezger, Manfred, Dipl.-Ing., D-7145 Markgröningen (DE)

(56) Entgegenhaltungen:
- WO-A-80/02881
- DE-A- 2 246 825
- DE-A- 2 606 067
- DE-A- 2 732 471
- FR-E- 2 284 927
- GB-A- 2 028 539
- GB-A- 2 103 836
- US-A- 4 366 541
- Electronic Design, Band 26, Nr. 21, Oktober 1978, Seite 138, Rochelle Park, N:J: US; "8-bit microprocessor, CMOS, CDP 1802"
- PROCEEDINGS OF THE FALL JOINT COMPUTER CONFERENCE, december 9-11, 1968, San Francisco, Band 33, Teil 1, Seiten 39-43; Thompson Washington, US; A.N. Higgins: "Error recovery through programming"

## Beschreibung

### Stand der Technik

Die Erfindung geht aus von einem Verfahren zur Programmierung von Steuergeräten für Kraftfahrzeuge nach der Gattung des Hauptanspruches.

Aus der Zeitschrift "Elektronik" Nr. 22, 1982, Seite 143 ff ist ein Gerät beschrieben, das mit einem Mikrocomputer, mit einer seriellen Schnittstelle und mit einem programmierbaren Speicher ausgerüstet ist. Über die serielle Schnittstelle können Daten auf den Mikrocomputer gegeben werden, der diese Daten mit Hilfe von Speicherdaten weiterverarbeitet. Durch Verändern der Speicherdaten ist ein solches Gerät flexibel einsetzbar. Dabei stellt jedoch die praktische Ausführung der Änderung ein Problem dar. Ist das Gerät in einem Gehäuse untergebracht und wird der Speicherinhalt durch Austausch von Speicher-IC's erreicht, so ist bei Einsatz in einem Kraftfahrzeug leicht Eindringen von Schmutz und/oder Feuchtigkeit in das Gehäuse möglich. Ist das Speicher-IC auf einen Sockel untergebracht, so ist der mechanischen Zuverlässigkeit des Gerätes eine Grenze gegeben.

Aus der DE-OS 27 32 471 ist ein elektronisches Motorsteuersystem mit einem Mikroprozessor bekannt, das elektrisch auf verschiedene Motortypen abgestimmt werden kann. Dazu ist in dem Motorsteuersystem ein PROM vorgesehen, der mit den spezifischen Daten für den jeweiligen Motortyp programmiert werden kann. Es sind zur Programmierung dem PROM Takt-Signale, Programmdaten-Signale und eine Programmierspannung zuzuführen.

Aus der DE-OS 22 46 825 ist ein Datenübertragungsverfahren zwischen einem Sender und einem Empfänger bekannt, bei dem eine Fehlerüberwachung durch Rückübertragung einer Quittungsmeldung ("richtig" oder "falsch) vom Empfänger zum Sender geschieht. Die Daten werden binär kodiert und blockweise übertragen. Zur Fehlerüberprüfung werden redundante Bits mit übertragen. Wurde ein Block als fehlerhaft übertragen erkannt, so wird dieser Block erneut übertragen. Nach mehrmaligen Fehlversuchen wird dann eine Fehlermeldung abgegeben.

Aus der DE-OS 26 06 067 ist ein Schnittstellenbaustein bekannt, der zur Adaption von Peripheriebausteinen wie Tastaturen, Druckern, Lese-, Schreib- und Zeichengeräten, etc. an einen Mikrocomputer dient. Dabei ist der Schnittstellenbaustein so ausgelegt, Daten im parallelen Wortformat zu empfangen und in ein serielles Datenformat umzuwandeln und umgekehrt Daten in seriellen Datenformat zu empfangen und in ein paralleles Datenformat umzuwandeln. Es ist mit dem Schnittstellenbaustein asynchrone Datenübertragung zwischen Mikrocomputer und Peripheriegerät möglich.

Aus der US-PS 4 366 541 ist ein Verfahren zur Steuerung eines Motors bekannt. Darin ist eine Korrektur von Sensorsignalen vorgesehen. Mit Hilfe einer Schaltereinheit wird dem Steuergerät mitgeteilt, welches Sensorsignal zu korrigieren ist. Den Korrekturwert kann das Steuergerät dann durch Einlesen/Auszählen von Eingangsignalen ermitteln, die mittels eines weiteren Schalters an unterschiedliche Eingänge des Mirocomputers angelegt werden. Der ermittelte Korrekturwert wird sodann in eine bestimmte Speicherzelle eines EAROM eingespeichert. Zusätzliche Schaltereinheiten müssen dazu am Steuergerät angebracht sein.

### Vorteile der Erfindung

Das erfindungsgemäße Verfahren mit den kennzeichnenden Merkmalen des Hauptanspruchs hat demgegenüber den Vorteil, daß mit ihm ein Steuergeräteabgleich mit Hilfe von Software-Daten ermöglicht wird, ohne daß dazu das Steuergerät geöffnet werden müßte. Somit entfallen aufwendige Abgleichvorgänge im Steuergerät selbst und ein bei der Produktion gewonnener Dichtigkeitszustand kann erhalten bleiben. Besonders vorteilhaft ist die Verwendung einer seriellen Schnittstelle, die über eine lösbare Steckverbindung zwischen dem Programmiergerät und dem Mikrocomputer angebracht ist. Somit ist ein Ausbau des Steuergerätes bei in Kraftfahrzeug eingebauten Steuergeräten zum Abgleich nicht erforderlich. Somit sind leicht Abgleichvorgänge zu Reparatur- und Wartungszwecken möglich.

Durch die in den Unteransprüchen aufgeführten Maßnahmen sind vorteilhafte Verbesserungen der Erfindung möglich. Die Verwendung einer seriellen Schnittstelle ermöglicht eine serielle Datenübertragung, die mit wenigen Leitungen auskommt und damit zu einer mechanisch robusteren und zuverlässigeren Steckverbindung führt. Mit einer direkten Verbindung zwischen der Schnittstelle und dem Speicher ist es möglich, den Speicher zu programmieren, ohne daß der Mikrocomputer damit beschäftigt werden muß. Eine besonders vorteilhafte Programmierung des Speichers ist möglich, wenn die Übertragung bidirektional auf einer Leitung geschieht, wobei eine andere Leitung dazu vorgesehen sein kann, eine Aktiv- oder Passiv-Meldung der Leitung abzugeben, d.h. hiermit ist es möglich, mehrere Geräte an einen seriellen Bus anzuschließen, die auch unterschiedliche Baudraten aufweisen können. Weiterhin kann die Parität der übertragenen Daten dazu benutzt werden, als Information eine Unterscheidung zwischen Geräteadresse und zu programmierenden Daten zu ermöglichen.

### Zeichnung

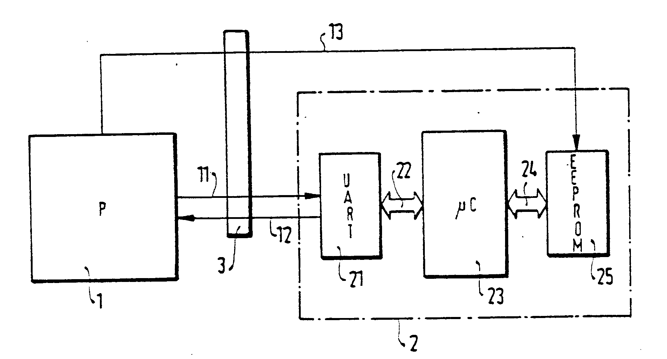

Ein Ausführungsbeispiel der Erfindung ist in der Zeichnung dargestellt und in der nachfolgenden Beschreibung näher erläutert. Die Zeichnung zeigt in symbolisierender Form ein Steuergerät, das an ein Programmiergerät angeschlossen ist.

### Beschreibung des Ausführungsbeispieles

In der Zeichnung ist ein Programmiergerät 1 über eine Sendeleitung 11 und eine Quittierleitung 12 mit einem Steuergerät 2 verbunden. Das Steuergerät 2 ist ein Steuergerät in einem Kraftfahrzeug, das verschiedene Funktionen wie Zündzeitpunktregelung, Schließwinkelregelung, Regelung der Einspritzzeitdauer, verschiedene Überwachungsfunktionen innerhalb des Kraftfahrzeuges etc. ausführt. Zur Vereinfachung der Darstellung ist aber nicht gezeigt, wie das Steuergerät 2 an verschiedene Sensoren und Stellglieder des Kraftfahrzeuges angeschlossen ist. Weiterhin ist zur Vereinfachung der Darstellung nicht gezeigt, daß eine Steckverbindung 3 fest mit einem Gehäuse des Steuergerätes 2 verbunden ist, so daß das Gehäuse das Steuergerät 2 dicht umschließt und ohne weiteres nicht geöffnet werden kann.

Das Steuergerät 2 weist wenigstens eine Schnittstelle 21, einen Mikrocomputer 23 und einen Speicher 25 auf. Die Sendeleitung 11 führt vom Programmiergerät 1 durch die Steckverbindung 3 auf die Schnittstelle 21, die Quittierleitung 12 führt von der Schnittstelle 21 durch die Steckverbindung 3 auf das Programmiergerät 1. Über einen Schnittstellenbus 22 ist der Mikrocomputer 23 mit der Schnittstelle 21, und über einen Speicherbus 24 ist der Mikrocomputer 23 mit dem Speicher 25 verbunden. Eine Freigabeleitung 13 führt vom Programmiergerät 1 durch die Steckverbindung 3 direkt auf den Speicher 25.

Im Normalbetrieb steuert der Mikrocomputer 23 verschiedene Funktionen im Kraftfahrzeug, wobei die fahrzeugspezifischen Daten im Speicher 25 abgelegt sind. Allgemeine Programme bzw. Daten, die für jeden Kraftfahrzeugtyp gültig sind, sind in einem weiteren, nicht näher dargestellten Speicher des Mikrocomputers 23 untergebracht. Nach der Herstellung des Steuergerätes 2 wird dieses im Gehäuse untergebracht, und mit der Steckverbindung 3, das am Gehäuse befestigt ist, verbunden, wie in der Zeichnung ersichtlich ist.

Das Programmiergerät 1 enthält sämtliche fahrzeugtypischen Daten, die im Speicher 25 untergebracht werden können, d.h. etwa für Benzinbestimmungen anderer Länder, oder für verschiedene Typenfunktionen innerhalb einer Fahrzeugserie, Spezifikationsänderungen innerhalb einer Produktserie usw. Das Programmiergerät 1 kann dabei beim Fahrzeughersteller oder beim Hersteller des Steuergerätes stehen. Zur Programmierung des Steuergerätes 2 wird das Programmiergerät 1 über die Sendeleitung 11, die Quittierleitung 12 und die Freigabeleitung 13 angeschlossen.

Der Mikrocomputer 23 besitzt wenigstens einen Mikroprozessor, verschiedene Ein- und Ausgabeports und wenigstens einen Festwertspeicher und einen Schreiblesespeicher. Es sind bereits Mikrocomputer bekannt, die eine serielle Schnitstelle besitzen, wie sie die serielle Schnittstelle 21 darstellt. Damit ist es ohne weiteres möglich, die serielle Schnittstelle 21 im Mikrocomputer 23 zu integrieren, das gleiche gilt für den Speicher 25.

Die serielle Schnittstelle 21 ist ein dem Fachmanne bekannt er elektronischer Baustein, ein sogenannter "Universal Asynchronous Receiver-Transmitter" (UART). Im Programmiergerät 1 ist ein solcher UART-Baustein als Empfänger für serielle Daten von der Quittierleitung 12 eingebaut.

Zur Programmierung des Steuergerätes 2 sendet das Programmiergerät 1 eine Adressierung an das Steuergerät 2. Die Adressierung wird mindestens dreimal in ungerader Parität gesendet. Nachdem das Steuergerät 2 mindestens dreimal ein Wort ungerader Parität empfangen hat, sendet es über die Quittierleitung 12 ein Quittiersignal an das Peripheriegerät 1. Damit erkennt das Peripheriegerät 1, daß das Steuergerät 2 empfangsbereit und programmierbereit ist.

Für diesen sogenannten Zweidrahtdialog zwischen Programmiergerät 1 und Steuergerät 2 gilt durchweg folgende Vereinbarung:
- Steuerbefehle haben ungerade Parität
- Daten/Adressen haben gerade Parität.
Zur Sicherstellung der Vereinbarung ist dazu im Datenformat ein Paritätsbit vorgesehen.

Nachdem die Verbindung zwischen dem Programmiergerät 1 und dem Steuergerät 2 hergestellt ist, sendet das Steuergerät 2 über die Quittierleitung 12 eine Kennung mit ungerader Parität. Daraufhin meldet sich das Programmiergerät 1 mit einem Befehl, der eine Programmierung des Speichers 25 ankündigt (Befehl ASCII "L" für "LADEN"). Danach folgen die Daten bzw. Adressen: Startadresse High, Startadresse Low, Anzahl der Datenbytes, Datenbit 1, Datenbit 2 etc. Nach jeder Adresse bzw. nach jedem Datum gibt das Steuergerät 2 ein Quittungssignal ab. Nachdem die angegebene Anzahl von Daten übertragen worden ist, gibt es ein Endsignal ab (Befehl ASCII "E"). Tritt während der Datenübertragung ein Bitfehler auf, den das Steuergerät 2 an der ungeraden Parität eines Datums erkennt, so sendet es einen Widerholungsbefehl an das Programmiergerät 1. Daraufhin wiederholt das Programmierungsgerät 1 das letzte Datum. Ist nach mehrmaligem Versuch das Datum immer noch nicht korrekt übertragen worden, so beendet das Programmiergerät 1 die Übertragung, nimmt an der Freigabeleitung 13 die Programmierspannung zurück und meldet sich mit einer Fehleranzeige für den Bediener.

Bei korrekter Übertragung, d.h. bei Erhalt eines Endbefehles vom Steuergerät 2, sendet das Programmiergerät 1 einen Verifizierbefehl (Befehl ASCII "V"). Daraufhin sendet das Steuergerät 2 die im Speicher 25 abgelegten Daten von der Startadresse bis zur Endadresse. Das Verfahren ist dabei das gleiche, wie bei der Übertragung vom Programmiergerät 1 zum Steuergerät 2. Im Programmiergerät 1 werden die Sendedaten mit den abgelegten und vom Gerät 2 übertragenen Daten verglichen. Bei korrekter Übertragung, d.h. bei gleichen Daten ist hiermit die Programmierung beendet. Bei fehlerhafter Übertragung wird der Programmiervorgang ein zweites Mal versucht. Tritt nach der zweiten Programmierung wieder ein Fehler auf, so beendet das Programmiergerät 1 die Programmierung und meldet sich mit einer Fehleranzeige für den Bediener.

Das Programmiergerät 1 ist so ausgelegt, daß sich anhand der zu sendenden und im Speicher abgelegten Daten ein Fehlerprotokoll ausdrucken läßt. Mann kann dann anhand der Fehlercharakteristik den Fehler einkreisen und beheben.

Das hier beschriebene Programierverfahren ist selbstverständlich nur eines von vielen möglichen. Insbesondere hängt die Art der Datenstruktur, bzw. die Realisierung des Handshakes zwischen Programmiergerät 1 und Steuergerät 2 von den jeweiligen Produktspezifikationen ab, die dem Fachmanne zur Verfügung stehen. Insbesondere ist auch eine synchrone serielle Datenübertragung über die Leitungen 11, 12 möglich, wobei auf einer Leitung Daten und auf der anderen Leitung ein Takt übertragen Im Steuergerät 2 bzw. Mikrocomputer 23 sind Analog/Digital-Wandler vorgesehen, die Ausgangssignale verschiedener, im Kraftfahrzeug vorhandener Sensoren wie etwa Temperatur der Ansaugluft, Druck im Ansaugrohr, Batteriespannung etc. erfassen. Mit Hilfe des Programmiergerätes 1 läßt sich ein programmgesteuerter Abgleich des Steuergerätes 2 durchführen, indem zum erfassten Wert innerhalb des Mikrocomputers 23 ein bestimmter Summand addiert wird, um so einen Offset abzugleichen, und/oder ein bestimmter Faktor multipliziert wird, um eine Verstärkung abzugleichen. Der Abgleich kann dabei elektronisch durch Bauteile- und Fertigungstoleranzen, Temperaturdrift etc. notwendig sein oder den routinemäßigen Abgleich von fahrzeugspezifischen Kenngrößen ersetzen.

Der Summand bzw. der Faktor wird dabei durch Vergleich mit einem Referenzwert bestimmt. Beispielsweise wird dazu an den Sensor zur Erfassung der Batteriespannung eine Referenzspannung angeschlossen, woraus über einen Analog/Digital-Wandler im Mikrocomputer ein zugehöriger Wert gebildet wird. Dieser Wert wird von Steuergerät 2 an das Programmiergerät 1 übertragen. Im Programmiergerät 1 ist ein Sollwert gespeichert, so daß bei Abweichung des Wertes vom Sollwert der Summand bzw. der Faktor gebildet wird, an das Steuergerät 2 übertragen und im Speicher 25 gespeichert wird. Bei zwei verschiedenen Referenzwerten kann eine Kennlinie linear abgeglichen werden, so daß sich ein Summand und ein Faktor ergibt. Mehrdimensionale Kennfelder bzw. parameterabhängige Kennlinien können so ebenfalls abgeglichen werden. Hierzu werden verschiedene Werte mit Referenzwerten verglichen, etwa bei parameterhafter Temperaturabhängigkeit in einem Wärmetunnel, in dem die Korrektursummanden bzw. -faktoren bestimmt und gespeichert werden. Während des Betriebes des Kraftfahrzeuges, d.h. verschiedenen Temperaturbedingen, werden dann im Mikrocomputer 23 die Korrekturwerte durch Interpolation ermittelt.

## Patentansprüche

1. Verfahren zur Programmierung von Steuergeräten für Kraftfahrzeuge, die wenigstens einen Speicher (25), der programmierbar und nicht flüchtig ist, einen auf den Speicher zurückgreifenden Mikrocomputer (23) und einen Bus aufweisen, über den das Steuergerät Daten erhält und der auf eine lösbare Steckverbindung (3) geführt ist, wobei zumindest die Datenübertragung seriell von einem Programmiergerät (1) durchgeführt wird, wobei ein Teil der übertragenen Daten in den Speicher (25) programmiert wird und wobei die Programmierung durch ein Signal an einer Freigabeleitung (13) freigegeben wird, dadurch gekennzeichnet, daß das Steuergerät (2) in einem geschlossenen Gehäuse untergebracht wird, daß die lösbare Steckverbindung (3) am Gehäuse befestigt wird und, daß durch weitere übertragene und gespeicherte Daten ein Steuergeräteabgleich durchgeführt wird, indem an wenigstens einem Sensoriengang des Steuergeräts (2) ein Referenzsignal angelegt wird, daß aus diesem Referenzsignal intern im Steuergerät (2) ein Referenzwert gebildet wird und der gebildete Referenzwert an das Programmiergerät übertragen und dort mit einem vorgegebenen Sollwert verglichen wird, und bei einer Abweichung des Referenzwertes vom Sollwert ein Korrektursummand und/oder ein Korrekturfaktor gebildet wird, der in den Speicher (25) eingeschrieben wird und, daß nach erfolgtem Abgleich die ermittelten Werte bei der Verarbeitung mit dem Korrektursummanden und/oder Korrekturfaktor gewichtet werden.

2. Verfahren nach Anspruch 1,
dadurch gekennzeichnet, daß
dem Steuergerät (2) eine serielle Schnittstelle (21) mit einer seriellen und einer parallelen Seite zugeordnet wird, und daß die Schnittstelle (21) über die parallele Seite mit dem Mikrocomputer (23) und/oder dem Speicher (25) verbunden wird.

3. Verfahren nach einem der Ansprüche 1 oder 2,
dadurch gekennzeichnet, daß
als Speicher (25) ein EEPROM oder ein NVRAM verwendet wird.

4. Verfahren nach einem der vorhergehenden Ansprüche, dadurch gekennzeichnet, daß die Datenübertragung über den Bus gemäß einem Handshake mit einer Sendeleitung (11) und einer Quittierleitung (12) erfolgt.

5. Verfahren nach Anspruch 4, dadurch gekennzeichnet, daß eine Datenübertragung vom Programmiergerät (1) zum Steuergerät (2) über die Sendeleitung (11) und eine Datenübertragung vom Gerät (2) zum Programmiergerät (1) über die Quittierleitung (12) erfolgt.

6. Verfahren nach Anspruch 4, dadurch gekennzeichnet, daß eine Datenübertragung zwischen Programmiergerät (1) und dem Steuergerät (2) bidirektional über die Sendeleitung (11) erfolgt, und daß die Quittierleitung (12) die Übertragungsrichtung anzeigt.

7. Verfahren nach einem der vorhergehenden Ansprüche, dadurch gekennzeichnet, daß Befehle für das Steuergerät (2) und/oder das Programmiergerät (1) mit anderer Parität übertragen werden als die zu programmierenden Daten samt dazugehörigen Verwaltungsdaten.

8. Verfahren nach einem der vorhergehenden Ansprüche, dadurch gekennzeichnet, daß nach jedem übertragenen Datenblock, vorzugsweise eines Byte, empfangsseitig der empfangene Datenblock auf Bitfehler geprüft wird, daß bei einem Bitfehler eine Wiederholung der Übertragung des Datenblocks durchgeführt wird, und daß ab einer vorgegebenen Anzahl von Wiederholungen der Übertragung des gleichen Datenblocks die Übertragung angehalten und eine Fehlermeldung ausgegeben wird.

9. Verfahren nach einem der vorhergehenden Ansprüche, dadurch gekennzeichnet, daß nach einer Übertragung der Daten vom Programmiergerät (1) zum Steuergerät (2) eine Übertragung der im Speicher (25) programmierten Daten vom Steuergerät (2) zum Programmiergerät (1) erfolgt, daß die Daten mit den vom Steuergerät (2) empfangenen Daten verglichen werden und daß bei Ungleichheit eine Fehlermeldung ausgegeben wird.

10. Verfahren nach Anspruch 9, dadurch gekennzeichnet, daß bei Ungleichheit eine erneute Übertragung der Daten durchgeführt wird und daß bei erneuter Ungleichheit eine Fehlermeldung ausgegeben wird.

11. Verfahren nach einem der vorhergehenden Ansprüche, dadurch gekennzeichnet, daß der Abgleich mehrdimensional oder parameterabhängig erfolgt und, daß nach erfolgtem Abgleich der Wert mit wenigstens einem interpolierten Korrekturwert gewichtet wird.

## Claims

1. Method of programming control devices for motor vehicles which have at least one memory (25), which is programmable and not volatile, one microcomputer (23) that accesses the memory, and one bus via which the control device receives data and which leads to a detachable plug connection (3), in which at least the data transmission is carried out serially from a programming device (1), in which some of the transmitted data is programmed into the memory (25), and in which the programming is enabled by means of a signal on an enable line (13), characterised in that the control device (2) is accommodated in a closed housing, in that the detachable plug connection (3) is fastened on the housing, and in that a control device adjustment is carried out by means of further data transmitted and stored, in that a reference signal is applied to at least one sensor input of the control device (2), in that a reference value is formed internally in the control device (2) from said reference signal and the reference value formed is transmitted to the programming device and compared there with a predetermined nominal value, and, if the reference value differs from the nominal value, a correction summand and/or a correction factor is formed, which is written into the memory (25), and in that, after completion of the adjustment, the values determined are weighted during the processing with the correction summand and/or correction factor.

2. Method according to Claim 1, characterised in that a serial interface (21) having a serial and a parallel side is associated with the control device (2), and in that the interface (21) is connected via the parallel side to the microcomputer (23) and/or the memory (25).

3. Method according to one of Claims 1 or 2, characterised in that an EEPROM or an NVRAM is employed as memory (25).

4. Method according to one of the preceding claims, characterised in that the data transmission is carried out via the bus in accordance with a handshake with a transmit line (11) and an acknowledge line (12).

5. Method according to Claim 4, characterised in that a data transmission from the programming device (1) to the control device (2) is carried out via the transmit line (11), and a data transmission from the device (2) to the programming device (1) is carried out via the acknowledge line (12).

6. Method according to Claim 4, characterised in that a data transmission between programming device (1) and the control device (2) is carried out bidirectionally via the transmit line (11), and in that the acknowledge line (12) indicates the transmission direction.

7. Method according to one of the preceding claims, characterised in that commands for the control device (2) and/or the programming device (1) are transmitted with a different parity than the data to be programmed including all the associated control data.

8. Method according to one of the preceding claims, characterised in that after each data block transmitted, preferably of one byte, the received data block is checked for bit errors at the receiving end, in that in the case of a bit error the transmission of the data block is repeated, and in that, from a predetermined number of repeated transmissions of the same data block, the transmission is halted and an error message is output.

9. Method according to one of the preceding claims, characterised in that after the data have been transmitted from the programming device (1) to the control device (2), the data programmed in the memory (25) are transmitted from the control device (2) to the programming device (1), in that the data are compared with the data received from the control device (2), and in that an error message is output if the data are not the same.

10. Method according to Claim 9, characterised in that if they are not the same, the data are transmitted once again, and in that an error message is output if they are not the same again.

11. Method according to one of the preceding claims, characterised in that the adjustment is carried out in a multidimensional or parameter-dependent manner, and in that after completion of the adjustment the value is weighted with at least one interpolated correction value.

## Revendications

1. Procédé pour programmer des dispositifs de commande pour véhicules à moteur, qui présentent au moins une mémoire (25), qui peut être programmé et n'est pas volatile, un micro-calculateur (23) en prise en retour sur la mémoire, et un bus par lequel le dispositif de commande reçoit des données et qui est branché sur une liaison par enfichage (3) détachable, au moins la transmission des données étant effectuée en série à partir d'un appareil de programmation (1), une partie des données transmises étant programmée dans la mémoire (25) et la programmation étant débloquée par un signal à une ligne de déblocage (13), procédé caractérisé en ce que le dispositif de commande (2) est placé dans un boîtier fermé, la liaison par enfichage (3) détachable est fixée sur le boîtier et en ce que l'on effectue un réglage du dispositif de commande par d'autres données transmises et mises en mémoire, pendant qu'est appliqué un signal de référence sur au moins une entrée de détecteur du dispositif de commande (2) et cependant que la valeur de référence formée est transmise à l'appareil de programmation et est comparée à une valeur de consigne prédéfinie, et que dans le cas d'un écart entre la valeur de référence et la valeur de consigne il est formé un élément d'addition de correction et/ou un facteur de correction, qui est enregistré dans la mémoire (25) et en ce que l'on pondère les valeurs détectées lors du retraitement, une fois effectué le réglage, par l'élément d'addition de correction et/ou le facteur de correction.

2. Procédé selon la revendication 1, caractérisé en ce que l'on associe au dispositif de commande (2) une interface en série (21) avec une face en série et une face en parallèle et en ce que l'interface (21) est reliée par la face en parallèle au micro-calculateur (23) et/ou à la mémoire (25).

3. Procédé selon la revendication 1 ou 2, caractérisé en ce que l'on utilise comme mémoire (25) une mémoire EEPROM (mémoire morte effaçable par voie électrique) ou une mémoire NVRAM.

4. Procédé selon l'une des revendications précédentes, caractérisé en ce que la transmission des données a lieu via le bus selon une jonction avec une ligne émettrice (11) et une ligne d'accusé de réception (12).

5. Procédé selon la revendication 4, caractérisé en ce qu'une transmission des données a lieu de l'appareil de programmation (1) au dispositif de commande (2) via la ligne d'émission (11) et une transmission de donnée a lieu du dispositif (2) à l'appareil de commande (1) via la ligne d'accusé de réception (12).

6. Procédé selon la revendication 4, caractérisé en ce qu'une transmission de données a lieu entre l'appareil de programmation (1) et le dispositif de commande (2) de façon bidirectionnelle via la ligne d'émission (11) et en ce que la ligne d'accusé de réception (12) indique le sens de transmission.

7. Procédé selon l'une des revendications précédentes, caractérisé en ce que des ordres pour le dispositif de commande (2) et/ou l'appareil de programmation (1) sont transmis avec une autre partie que les données à programmer ainsi que les données correspondantes d'administration.

8. Procédé selon l'une des revendications précédentes, caractérisé en ce qu'après chaque bloc de données transmis de préférence d'un multiplet, on vérifie du côté réception le bloc de données reçu pour savoir s'il n'y a pas d'erreur de bit, en ce que dans le cas d'une erreur de bit on effectue une répétition de la transmission du bloc de données, et en ce qu'à partir d'un nombre prédéfini de répétition de la transmission du même bloc de données on arrête la transmission et on délivre une indication d'erreur.

9. Procédé selon l'une des revendications précédentes, caractérisé en ce qu'après une transmission des données de l'appareil de programmation (1) au dispositif de commande (2) a lieu une transmission des données programmées dans la mémoire (25) du dispositif de commande (2) à l'appareil de programmation (1), en ce que les données sont comparées aux données reçues du dispositif de commande (2) et en ce que l'on délivre en cas d'inégalité un indication d'erreur.

10. Procédé selon la revendication 9, caractérisé en ce qu'en cas d'inégalité on effectue une nouvelle transmission des données et en cas d'inégalité renouvelée on délivre une indication de défaut.

11. Procédé selon l'une des revendications précédentes, caractérisé en ce que le réglage a lieu de façon pluridimensionnelle ou en fonction de paramètres et en ce qu'une fois que le réglage a eu lieu la valeur est pondérée avec au moins une valeur de correction interpolée.
